# EUROPÄISCHE PATENTSCHRIFT

(11) **EP 0 937 786 B1**
(45) Veröffentlichungstag und Bekanntmachung des Hinweises auf die Patenterteilung: **16.04.2008**
(21) Anmeldenummer: 99102511.5
(22) Anmeldetag: 10.02.1999
(51) Int. Cl.: C23C 28/00, C23C 14/08, F01D 5/18

(54) **Wärmedämmschichtsystem mit integrierter Aluminiumoxidschicht**
Thermal barrier coating system having an integrated alumina layer
Système de revêtement de barrière thermique avec une couche d'alumine intégrée

(30) Priorität: 21.02.1998 DE 19807359
(43) Veröffentlichungstag der Anmeldung: 25.08.1999
(73) Patentinhaber: Deutsches Zentrum für Luft- und Raumfahrt e.V., 51147 Köln (DE)
(72) Erfinder: Schulz, Uwe Dr., 53842 Troisdorf (DE); Leyens, Christoph Dr., 53639 Königswinter (DE); Krell, Thomas, 40625 Düsseldorf (DE); Leushake, Uwe, 51377 Leverkusen (DE)
(74) Vertreter: Jönsson, Hans-Peter

(56) Entgegenhaltungen:
- EP-A- 0 705 912
- WO-A-96/34129
- US-A- 5 683 761
- PRAKASH S ET AL: "Pretreatment effects on the morphology and properties of aluminum oxide thermally grown on NiCoCrAlY" PROCEEDINGS OF THE 12TH INTERNATIONAL CONFERENCE ON METALLURGICAL COATINGS, LOS ANGELES, CA, USA, 15-19 APRIL 1985, Bd. 3, Nr. 6, Seiten 2551-2556, XP002162476 Journal of Vacuum Science & Technology A (Vacuum, Surfaces, and Films), Nov.-Dec. 1985, USA ISSN: 0734-2101
- THORNTON J A ET AL: "STRUCTURE AND HEAT TREATMENT CHARACTERISTICS OF SPUTTER-DEPOSITED ALUMINA" AMERICAN CERAMIC SOCIETY BULLETIN,US,AMERICAN CERAMIC SOCIETY. COLUMBUS, Bd. 56, Nr. 5, 1. Mai 1977 (1977-05-01), Seiten 504-508, XP000601547 ISSN: 0002-7812
- LEUSHAKE U ET AL: "Microstructure and phase stability of EB-PVD alumina and alumina/zirconia for thermal barrier coating applications" 24TH INTERNATIONAL CONFERENCE ON METALLURGICAL COATINGS AND THIN FILMS, SAN DIEGO, CA, USA, 21-25 APRIL 1997, Bd. 94-95, Nr. 1-3, Seiten 131-136, XP000991527 Surface and Coatings Technology, Oct. 1997, Elsevier, Switzerland ISSN: 0257-8972
- WANG ET AL: "THE EFFECT OF REACTIVELY-SPUTTERED ALUMINA FILMS ON THE OXIDATION OF CoCrAlY COATINGS." JOURNAL DE PHYSIQUE, Bd. 3, Nr. C9, Dezember 1993 (1993-12), Seiten 551-557, XP000991478 FR

## Beschreibung

Gegenstand der Erfindung ist ein Verfahren zum Beschichten von metallischen Substraten mit einem Wärmedämmschichtsystem und die so erhältlichen Bauteile.

Wärmedämmschichten (WDS) eignen sich zur Verringerung der thermischen Verluste von gekühlten Bauteilen wie z.B. innengekühlten Turbinenschaufeln und Brennkammerwänden in stationären und Flugturbinen. Gleichzeitig läßt sich durch den Einsatz von WDS der Wirkungsgrad beispielsweise von Turbinen erhöhen. Als besonders wirksam hat sich dabei das Verfahren der Elektronenstrahl-Aufdampfung (EP-PVD, engl. electron beam - physical vapour deposition) von Y₂O₃ -teilstabilisiertem Zirkonoxid (YSZ) erwiesen. Aufgrund ihrer meist kolumnaren Ausbildung besitzen diese WDS eine gute Thermoschockbeständigkeit und die bei Keramiken normalerweise nicht auftretende Eigenschaft einer gewissen Dehnungstoleranz.

Ein komplettes Wärmedämmschichtsystem besteht in der Regel aus oxidations- und korrosionsbeständiger Zwischenschicht auf dem Bauteil, einer keramischen Wärmedämmschicht und einer sich im Laufe der Herstellung bzw. im Einsatz ausbildenden dünnen Metalloxidschicht (TGO) als Sauerstoffdiffusionsbarriere und Haftzone zwischen beiden. Dieses TGO (deutsch: thermisch gewachsenes Oxid) soll vorzugsweise aus α-Aluminiumoxid bestehen, da dieses eine sehr niedrige Sauerstoffdurchlässigkeit besitzt. Aluminiumoxid kann außer in der thermodynamisch stabilen α-Modifikation auch in einer Vielzahl von in der Regel metastabilen Übergangsmodifikationen mit geringerer Oxidationsschutzwirkung auftreten.

Der Ausfall eines solchen Schichtsystems erfolgt zumeist durch Abplatzen der Wärmedämmschicht im Interfacebereich zwischen Metall und Keramik, wobei eine Vielzahl von Ursachen für das Versagen verantwortlich sein kann. Neben der chemischen Zusammensetzung, dem Oxidations-, Korrosions- und Kriechverhalten der Zwischenschicht spielt auch die Bauteilgeometrie sowie die chemische Zusammensetzung des Substrats und dessen Ordnungsgrad (Einkristall, Polykristall, gerichtet erstarrt) eine Rolle.

Dem Interface Zwischenschicht/Wärmedämmschicht und der Ausbildung des thermisch wachsenden Oxids kommt eine zentrale Bedeutung zu, da die Haftung von Elektronen-Strahl-Verdampften WDS hauptsächlich chemischer Natur ist. Diese Übergangsstelle Zwischenschicht/Wärmedämmschicht ist im Einsatz bzw. in simulierenden thermozyklischen Tests die vorherrschende Ausfallstelle des Schichtsystems. Neben thermomechanischen Spannungen ist das Wachstum des TGOs, das sich beispielsweise auf einer MCrAlY-Schicht bildendet, ein Hauptgrund für das Abplatzen der Keramik, da die Oxidation mit einer Volumenzunahme und somit auch mit einer Zunahme von Spannungen verbunden ist.

Die Lebensdauer der Wärmedämmschichten auf ihren Substraten wird durch das Auftreten von überkritischen Spannungen zwischen Metallsubstrat und Keramikschicht begrenzt. Alle Maßnahmen einer Lebensdauerverlängerrung müssen demzufolge immer daraufhin abzielen, diese Spannungen möglichst lange unterkritisch zu halten.

Die Herstellung kolumnarer Wärmedämmschichten mittels EB-PVD-Verfahren ist hinlänglich beschrieben und auch in der Patentliteratur dokumentiert (US-A 4 321 311 und EP 0 042 872 B1; US-A 5 262 245; US-A 4 676 994). Auch andere Ausbildungen der Wärmedämmschicht, z.B. keulenartig (noch unveröffentlichte DE 197 15 791 A), mit unterschiedlicher Ausbildung der Porosität (US-A 5 512 382), verdichteten Lagen zur Erhöhung der Erosionsbeständigkeit (US-A 5 350 599), gradierten Ausbildungen der Wärmedämmschicht (US-A 5 236 787), oder lagenartigem Aufbau unterschiedlicher Struktur (EP 0 705 912 A2) sind bekannt.

Die Nachteile von herkömmlichen Duplex-Schichtsystemen (metallische Zwischenschicht plus keramische WDS) sind in der Literatur ausführlich beschrieben worden. Als wichtigstes sind die hohen Oxidationsraten der metallischen Zwischenschichten, die damit verbundenen Wachstumsspannungen im TGO an der Grenzfläche Metall / Metalloxid sowie die Haftungsprobleme von Wärmedämmschichten auf den thermisch gewachsenen Oxiden anzuführen (K. Fritscher et al.: Grenzschicht-Problematik und Haftung von EB-PVD Wärmedämmschichtsystemen. Materialwissenschaft und Werkstofftechnik 28 (1997) S. 384-390). Negativ wirkt sich die Bildung von Spinell-Oxiden, Chromoxiden oder der Übergangsmodifikationen des Aluminiumoxids im TGO aus, die aufgrund kinetischer Aspekte an realen Schichtsystemen häufig beobachtet wurden (Schmücker, M. et al.: Haftmechanismen in ausgewählten EB-PVD-Wärmedämmschichtsystemen. Fortschrittsberichte der DKG, Werkstoffe, Verfahren, Anwendung 10 (1995) 4; S. 379-384; Fritscher, K. et al: TEM Investigation on the adhesion of EB-PVD thermal barrier coatings. Materials Science Forum Vol. 251-254 (1997) 965-970. Diese und andere Faktoren begrenzen die Lebensdauer von Wärmedämmschichten auf Turbinenbauteilen, beispielsweise auf Turbinenlaufschaufeln.

Die Haftung der WDS auf den Zwischenschichten beruht hauptsächlich auf der chemischen Verbindung zwischen Al₂O₃ und ZrO₂ (Strangmann, T.E. et al.: Tailoring zirconia coatings for performance in a marine gas turbine environment. ASME J. Eng. Gas Turbines Power 112 (1990), S. 531-535), wobei geringe Löslichkeiten des Zr im Al₂O₃ des TGO oder des Al im ZrO₂ als hauptsächlicher Haftmechanismus angesehen werden (US-A 4 321 311 und EP 0 042 872 B1; Meier, S.M. et al.: The evolution of thermal barrier coatings in gas turbine engine applications. ASME paper 92-GT-203 (1992); EP 0 044 329 B1). Das TGO, welches bevorzugt Al₂O₃ sein soll, wird dabei stets durch selektive Oxidation der metallischen Zwischenschicht erzeugt.

Eine glatte Oberfläche mit thermisch gewachsenem Al₂O₃ als Untergrund für gedampfte Wärmedämmschichten verbessert deren Haftung entscheidend. MCrAlY-Zwischenschichten können beispielsweise vor der Oxidation poliert werden, was zu erheblich längeren Lebensdauern führt (EP 0 044 329 B1).

Eine chemisch aus der Dampfphase (CVD) abgeschiedene Sauerstoffdiffusionsbarriere aus Al₂O₃ von 2-9 µm auf einer NiCrAIY-Vakuum-Plasmaspritz-Zwischenschicht erbrachte deutlich geringere Oxidationsraten im Vergleich zu Zuständen ohne CVD-Layer. Die darüber aufgebrachte Wärmedämmschicht bestand aus einer nichtkolumnaren, durch Plasmaspritzen (PS) erzeugten 8 Gew.-% Y₂O₃ -ZrO₂ Wärmedämmschicht mit dem für PS typischen, sehr rauhen Interface Zwischenschicht/WDS. Eine Erhöhung der zyklischen Lebensdauer wurde nur bei Verwendung von höheren Abscheidetemperaturen (>1000°C) während des CVD-Prozesses erreicht, was auf unterschiedliche Morphologien der Aluminiumoxidschicht zurückgeführt wurde. Bei 1100°C Testtemperatur (1 stündige Zyklen mit Abkühlung) wurde eine Zunahme der Lebensdauer von 35 auf 55 Zyklen durch die CVD-Al₂O₃-Schicht gefunden. Die optimale Dicke der CVD- Aluminiumoxidschicht wurde mit 3-7 µm angegeben, wobei mit zunehmender Dicke eine geringere Oxidationsrate ermittelt wurde. Eine Wärmebehandlung des Al₂O₃ nach dem CVD-Prozeß wurde nicht vorgenommen (Sun, J.H. et al.: The properties and performance of (ZrO2-8 wt% Y2O3)/(chemically vapour-deposited Al2O3)/(Ni-22 wt% Cr-10 wt% AI-1 wt%) thermal barrier coatings. Surface and Coatings Technology 58 (1993) S. 93-99; Sun, J.H. et al.: The spalling modes and degradation of ZrO2-8 wt% Y2O3CVD-Al2O3Ni-22Cr-10Al-1Y thermal barrier coatings. Oxidation of Metals 40 (1993), S. 465-481; Sun, J.H. et al.: Performance of CVD Al2O3 intermediate layer between zirconia top coat and NiCrAlY bond coat. Materials Trans., JIM, 34 (1993) 7, S. 614-621).

Eine Diffusionssperrschicht für Sauerstoff aus Al₂O₃ auf plasmagespritztem MCrAIY kann die isotherme Oxidationsrate bei 1000°C und die Dicke des sich dabei bildendenden Oxids herabsenken. Dies wurde für Aluminiumoxidschichten gefunden, welche durch reaktives Sputtern von Aluminium oder durch CVD hergestellt wurden. Probleme bereitete bereits nach 250 Stunden bei 1000°C das Auftreten von Rissen im Aluminiumoxid bei gesputtertem Al₂O₃ bzw. bei CVD-Schichten die Glättung der MCrAlY-Oberfläche sowie stengelförmige Oxide direkt nach der Herstellung (Schmitt-Thomas, Kh.G. et al.: Diffusionssperrschichten aus Al2O3 zur Beeinflussung der Haftschichtoxidation von McrAlY-Legierungen. Werkstoffe und Korr. 43(1992), S. 492-495). Ähnliches wurde für gesputterte CoCrAIYSchichten mit reaktiv gesputtertem Al₂O₃ in (Wang, F. et al.: The effect of reactively-sputtered alumina films on the oxidation resistance of CoCrAIY coatings. Journal de Physique IV, C9 3(1993) S. 551-557) gefunden.

Gesputterte Aluminiumoxidschichten von 1,7 bis 4,9µm Dicke als Diffusionsbarriere erwiesen sich auch mit darüber liegender, nichtkolumnarer plasmagespritzter Wärmedämmschicht hilfreich bei der Verminderung der Oxidation. Nachgewiesen wurde die Verminderung der Metalloxiddicke (TGO) durch die Al₂O₃-Diffusionsbarriere unter isothermer Oxidation bei 1000 bis 1150°C. Je dicker die Diffusionsbarriere war, um so stärker war die Reduktion der TGO-Dicke (Schmitt-Thomas, Kh. G. et al.: Thermal barrier coatings with improved oxidation resistance. Surface and Coatings Technology, 68/69 (1994), S. 113-115).

In der Patentliteratur existiert bereits die Beschreibung von CVD-Aluminiumoxidschichten auf einem MCrAlY-EB-PVD-Bondcoat mit darüber liegender kolumnarer EB-PVD Wärmedämmschicht (US-A 4 880 614 und US-A 5 015 502). Der Schwerpunkt liegt dabei auf der hohen Reinheit und Porenfreiheit der Aluminiumoxidschicht. Mit einer solchen Schichtkombination wurde im Heißgasversuch bei 1150°C/27min und Abkühlung auf Raumtemperatur in 3 min eine bis zu vierfach längere Zeit bis zum Abplatzen der Wärmedämmschicht im Vergleich zu Schichten ohne Al₂O₃ erreicht. Als mögliche Ursachen wurden die hohe Reinheit des CVD-Al₂O₃die verringerte Oxidationsrate sowie eine höhere Interfacezähigkeit angeführt. Das Patent umfaßt auch die Verwendung von Diffusions-Alitierschichten als Zwischenschicht.

WO 96/34129 A1 beschreibt eine Aluminiumoxidschicht, die stets Stickstoff in Gehalten von mindestens einigen Atom% enthält. Dies dient der Einbringung von Gitterstörungen, was zur Verminderung der Diffusion von Elementen durch die Schicht führt. Gleichzeitig wird aber durch Störungen im Gitter die Sauerstoffdiffusion, insbesondere an Korngrenzen in erheblicher Weise gegenüber alpha-Aluminiumoxid erhöht. Gegenstand der WO 96/34129 ist die stickstoffdotierte Aluminiumoxidschicht (ohne Angaben zur Modifikation), welche zur Verminderung der Diffusion schädlicher aktiver Elemente wie Hf, Ti, W oder Si aus der Superlegierung in die Wärmedämmschicht dient. Auch werden weitere Zusätze zum Aluminiumoxid oder Mischungen mit Chromoxid zugelassen. Die angeführte Wärmebehandlung dient lediglich zum Einbringen des Stickstoffs in die Aluminiumoxidschicht.

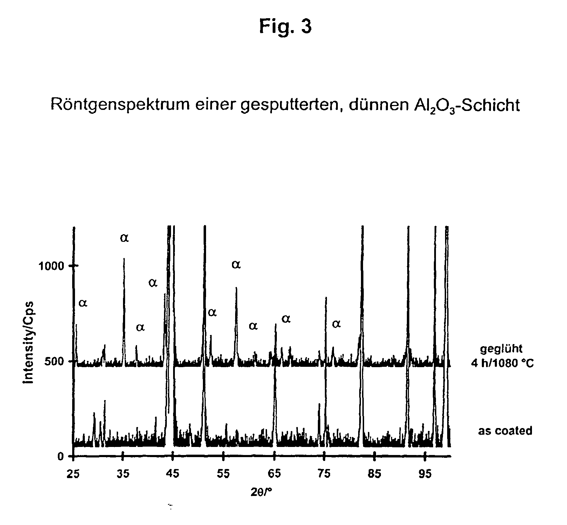

US 5,683,761 C beschreibt eine schützende Beschichtung mit insbesondere verbessertem Erosionswiderstand, Korrosionswiderstand sowie Partikelprallverschleiß (impact). Aus der Beschreibung zu Fig. 3 wird deutlich, daß Route B eine Einzellage alpha-Aluminiumoxid beinhaltet, die als Wärmedämmschicht fungiert. Die bevorzugte Route C besteht aus einer zweiten Keramikschicht, über der die alpha-Aluminiumoxidschicht aufgebracht wird. Route A hingegen beschreibt die Abscheidung des alpha-Aluminiumoids bei einer Temperatur des Substrats größer 1800 °F (982°C) durch Erhitzen des mit bondcoat versehenen Substrats. Die alpha-Aluminiumoxidschicht wird ausschließlich mittels "electron-beam physical vapour deposition" aufgebracht. Die Abscheidung des α-Al₂O₃ muß dabei in jedem Falle bei Temperaturen über 982 °C erfolgen.

Die Aufgabe der Erfindung besteht in der gezielten und reproduzierbaren Herstellung einer α-Al₂O₃ -Schicht auf der Zwischenschicht oder direkt auf einem Substrat geringer Oxidationsneigung (z.B. NiAl) mittels Elektronenstrahl-Aufdampt-Verfahren. Der Aufbringung von Aluminiumoxid ist bei Abscheidung mit niedrigen Substrattemperaturen eine Wärmebehandlung nachgeschaltet, welche für die Erzeugung der gewünschten α-Modifikation notwendig ist. Auf die α-Al₂O₃-Schicht wird mittels Elektronenstrahl-Aufdampfung die bekannte kolumnare oder auch anders ausgebildete (beispielsweise keulenartige) Wärmedämmschicht aufgebracht. Dieses neuartige Schichtsystem dient der Verlängerung der Lebensdauer von Bauteilen in hochtemperaturbelasteten Anwendungen, vornehmlich in einer Turbine.

In einer ersten Ausführungsform betrifft die vorliegende Erfindung ein Verfahren zum Beschichten von metallischen Substraten mit einer Metalloxidschicht aus Aluminiumoxid und einer oxidischen Wärmedämmschicht, in dem man
a) das Substrat mit einer 1 bis 10 µm dicken α-Aluminiumoxidschicht durch physikalische Dampfphasen-Abscheidung (PVD) bei einer Temperatur des Substrats im Bereich bis 900 °C, mit einer nachgeschalteten Wärmebehandlung des beschichteten Substrats im Temperatur bereich von 900°C bis 1250°C im Verlauf von wenigstens 0,5 Stunden und
b) die gemäß a) erhaltene α-Aluminiumoxidbeschichtung in an sich bekannter Weise mit einer Wärmedämmschicht einer Wärmeleitfähigkeit < 3 W/mK und einer Dicke von 10 bis 1000 µm
versieht.

Weiterhin bevorzugte Ausführungsformen sind den nachgeordneten Ansprüchen zu entnehmen.

Der wesentliche Unterschied zur Bildung des TGO durch Metalloxidation mit all ihren thermodynamischen und kinetischen Unwägbarkeiten besteht also in der erfindungsgemäßen gezielten Herstellung der Oxidations- beziehungsweise Korrosionsbarriere.

Gegebenenfalls kann vor der Aufbringung der α-Al₂O₃-Schicht eine an sich bekannte Zwischenschicht aufgebracht werden. Als Zwischenschichten kommen entweder Diffusions-Schichten mit Aluminium als wesentlichem Bestandteil MAIYX- oder MCrAlYX-Schichten (M= Ni, Co, Fe oder Gemische, X= optionale Zusatzelemente wie z.B. Ta, Re, Hf, Si oder ähnliche) zur Anwendung. MCrAlYX-Schichten werden bevorzugt durch Plasma-Spritzen oder Elektronenstrahl-Aufdampfen, aber auch durch Sputtern, CVD oder andere PVD-Verfahren hergestellt. Eine weitere Möglichkeit besteht in der elektrochemischen Abscheidung.

Der Duplex-Schichtaufbau Zwischenschicht/Wärmedämmschicht ist der im Einsatz übliche Fall auf Turbinenschaufeln moderner Hochdruckturbinen.

Keine der angeführten Stellen zum Stand der Technik macht Aussagen zu einer Wärmebehandlung oder zur direkten Phasenausbildung des Aluminiumoxids. Dies wird als entscheidender Nachteil des derzeitigen Standes der Technik gesehen, da nur die α-Modikation des Al₂O₃die Vorzüge einer geringen Sauerstoffdurchlässigkeit und der Hochtemperaturstabilität bietet. Besonders schädlich ist die Phasenumwandlung der Übergangsoxide δ oder Θ in die stabile α-Form, da sie mit einer Volumenänderung und somit mit erheblichen Spannungen verbunden ist.

Der wesentliche Vorteil der vorliegenden Erfindung ist die Herstellung der alpha-Modifikation des Aluminiumoxids durch die Glühbehandlung. Gegenüber dem Stand der Technik ergibt sich der Vorteil der Vorwegnahme von Sinterschrumpfungen und die möglichst vollständige Umwandlung der gesamten Oxidschicht in alpha-Aluminiumoxid, was bei der in-situ alpha-Aluminiumoxidabscheidung entsprechend Route A von US 5,683,761 C nicht oder nur bei sehr hohen und für das Substrat schädlichen Temperaturen gelingt.

Kerngedanke der Erfindung ist somit die gezielte Herstellung von α-Aluminiumoxidschichten auf metallischen Substraten mit einer darüber liegenden EB-PVD-Wärmedämmschicht. Die Erfindung umfaßt insbesondere:
- einen metallischen Hochtemperaturwerkstoff als Substrat, vorzugsweise eine Ni- oder Co-Basis-Superlegierung in einkristalliner, polykristalliner oder gerichtet erstarrter Form;
- eine optional darauf aufbauende metallische Zwischenschicht, beispielsweise aus der Gruppe der MCrAlYX-Schichten (M= Ni, Co, Fe oder deren Gemische, X= optionale Zusatzelemente insbesondere Ta, Re, Hf, Si oder ähnliche) oder eine Diffusionsschicht im wesentlichen aus Aluminium oder seine Legierungen. Bei oxidationsbeständigen Substratlegierungen kann diese metallische Zwischenschicht entfallen;
- das Aufbringverfahren für die metallische Zwischenschicht ist erfindungsgemäß beliebig und nicht von besonderer Relevanz. Beispielsweise kommen Plasmaspritzen (PS), Elektronenstrahl-Aufdampfen (EB-PVD), aber auch Sputtern, CVD oder andere PVD-Verfahren zur Anwendung;
- eine 1-10µm dicke α-Aluminiumoxidschicht wird auf dem Substrat oder auf der metallischen Zwischenschicht abgeschieden;
- die Herstellung der α-Aluminiumoxid-Schicht erfolgt mittels PVD-Verfahren bei einer Temperatur des Substrats im Bereich bis 900 °C, bevorzugt mittels Magnetron-Sputtern oder EB-PVD. Bei beiden Verfahren ist die reaktive Arbeitsweise (Verdampfen oder Abstäuben metallischen Aluminiums und Reaktion mit Sauerstoff in der Gasphase zum Oxid) oder das direkte Verdampfen oder Abstäuben von Aluminiumoxidtargets und/oder -ingots möglich. Die direkte Verdampfung oder Abstäubung vom Aluminiumoxidmaterial ist sowohl mit als auch ohne Sauerstoffzugabe möglich;
- bei Abscheidung unterhalb 900°C schließt sich eine Wärmebehandlung des aluminiumoxidbeschichteten Bauteils im Temperaturbereich zwischen 950°C und 1250°C für mindestens 0,5 Stunden zur Erzeugung der α-Phase und zur Relaxation der Aluminiumoxidschichten an. Bevorzugt wird für magnetron-gesputterte Schichten 4h/1080°C und für EB-PVD Schichten 9 h /1100°C verwendet. Die Wärmebehandlung kann gegebenenfalls mit der üblichen Diffusionsglühung der Zwischenschichten kombiniert werden, wodurch eine Zunahme der Prozeßschritte vermieden wird;
- die Abscheidung einer 10-1 000µm dicken oxidischen Wärmedämmschicht mit einer Wärmeleitfähigkeit kleiner als 3 W/mK auf diese α-Al₂O₃-Schicht mittels EB-PVD. Dabei entsteht eine kolumnare oder anders ausgebildete, jedoch stets poröse wärmedämmende Schicht. Aus Erosions- oder Korrosionsgründen können noch weitere Deckschichten über der Wärmedämmschicht aufgebracht werden;
- als Material für die Wärmedämmschicht kommen bevorzugt ZrO₂-haltige Keramiken, gegebenenfalls stabilisiert mit Y₂O₃, CeO₂, MgO, Sc₂O₃ oder anderen seltenen Erdmetalloxiden, zur Anwendung. Mullit, Zirkonsilikat, HfO₂ oder hochporöses Al₂O₃ sind ebenfalls als WDS einsetzbar. Die chemische Zusammensetzung der Wärmedämmschicht ist nicht von besonderer Bedeutung für die vorliegende Erfindung.

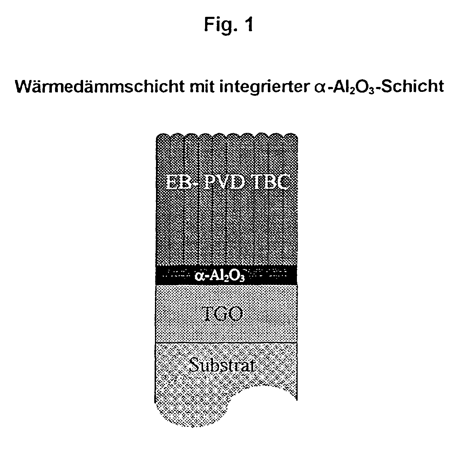

Der Aufbau eines Wärmedämmschichtsystems, welches erfindungsgemäß ausgeführt ist, wird in Fig. 1 deutlich.

Die wesentlichen Vorteile eines erfindungsgemäß aufgebrachten Schichtsystems liegen in der deutlich erhöhten zyklischen Lebensdauer sowie in einer verbesserten Haftung der Wärmedämmschicht auf dem α-Al₂O₃.

Die Nachteile des Stands der Technik werden erfindungsgemäß überwunden, da die α-Modifikation des Al₂O₃, welche die Vorzüge einer geringen Sauerstoffdurchlässigkeit und der Hochtemperaturstabilität bietet, direkt erzeugt wird und somit die Phasenumwandlung von den Al-Übergangsoxiden δ oder Θ in die stabile α-Form noch ohne darüber liegende Wärmedämmschicht abläuft und somit Spannungen durch Volumenänderung vermieden werden. Weiterhin ist zu erwarten, daß die bei herkömmlichen Duplex-Schichtsystemen bekannten hohen Oxidationsraten der metallischen Zwischenschichten verringert werden, was die damit verbundenen Wachstumsspannungen im TGO beim Übergang Metall--->Metalloxid herabsetzt. Die Anbindung der Wärmedämmschicht erfolgt direkt auf der optimalen Modifikation des α-Al₂O₃ und nicht beispielsweise auftretenden Spinell-Oxiden, Chromoxiden oder den genannten Übergangsmodifikationen des Aluminiumoxids, was eine verbesserte Haftung und somit eine erhöhte Lebensdauer bedeutet.

Eine weitere Ausführungsform der Erfindung betrifft die mit Hilfe des Verfahrens erhältlichen Bauteile, insbesondere innengekühlte Turbinenschaufeln oder Brennkammerwände in stationären oder Flugturbinen.

### Ausführungsbeispiele

### Beispiel 1:

### Aluminiumoxidverdampfung mittels EB-PVD und Erzeugung von α-Al₂O₃

In Tabelle 1 sind die verwendeten Prozeßparameter bei der EB-PVD-Verdampfung von Aluminiumoxid zur Herstellung dicker Schichten aus Al₂O₃ (>20µm) dargestellt.

**Tabelle 1:**

| EB-PVD -Beschichtungsbedingungen für Aluminiumoxid | | | | |
|---|---|---|---|---|
| **Substrattemperatur** | | **Run 1** | **Run 2** | **Run 3** |
| **Vorheizen** | [°C] | 960 | 1000 | 1090-995 |
| **Beschichten** | [°C] | 960-890 | 800 | 3*1060-995 |
| **Kammerdrücke** | mbar | <1.0e-3 | 4.3e-3 | 4.0e-3 |

Run 1 wurde ohne Sauerstoffzugabe, Run 2 und 3 reaktiv mit Sauerstoffzugabe gefahren. Bei Run 3 wurde die Beschichtung in 3 Stufen mit zwischenzeitlicher Heizung des Substrates in der Vorheizkammer durchgeführt. Neben der Phasenausbildung hängen Morphologie und Beschichtungrate ebenfalls von den gewählten Parametern ab. U. Leushake, T. Krell, U. Schulz, M. Peters, W.A. Kaysser, B.H. Rabin: Microstructure and Phase Stability of EB-PVD alumina and alumina/zirconia for thermal barrier coating applications. Surface and Coatings Technology 94-95 (1997) 131-136.

Die Phasenausbildung im Zustand nach der Beschichtung sowie nach Wärmebehandlungen mit verschiedenen Zeiten und Temperaturen zeigt Tabelle 2. Die Phasenanalyse mittels Röntgenbeugung erfolgte wegen der Textur der Schichten nur qualitativ.

**Tabelle 2:**

| Phasenzusammensetzung von EB-PVD Al₂O₃-Schichten vor und nach einer Wärmebehandlung | | | | | | | | | | | | | | | | | | | | | |
|---|---|---|---|---|---|---|---|---|---|---|---|---|---|---|---|---|---|---|---|---|---|
| Al₂O₃ Phase Run | nach dem Auftrag en | | | 1000 °C | | | | | | 1100°C | | | | | | 1200 °C | | | | | |
| | | | | 1h | | | 9h | | | 1h | | | 9h | | | 1h | | | 9h | | |
| | 1 | 2 | 3 | 1 | 2 | 3 | 1 | 2 | 3 | 1 | 2 | 3 | 1 | 2 | 3 | 1 | 2 | 3 | 1 | 2 | 3 |
| α | x | | | x | | | x | x | | x | x | | x | x | x | x | x | x | x | x | x |
| Θ | | | x | | | x | | | x | | | x | | | x | | | x | | | |
| δ | | x | x | | x | x | | x | x | | x | x | | x | x | | x | x | | x | |

Man erkennt die in situ-Bildung von α-Aluminiumoxid bei hohen Substrattemperaturen von mehr als 900°C (Run 1 as coated). Bei Substrattemperaturen unterhalb 900°C treten entweder Gemische aus Θ und δ-Phase auf oder nur δ (Run 2 und 3). Noch niedrigere Substrattemperaturen zeigten wachsende Anteile von amorphem Al₂O₃.

Die Phasenumwandlung in die α-Phase war nach 9 Stunden bei 1000°C zu beobachten und ist bis auf geringe Restmengen der Ausgangsphasen nach 9 Stunden bei 1200°C abgeschlossen. Eine niedrigere Abscheidetemperatur verringert die notwendige Zeit bzw. Temperatur, die für die α-Bildung notwendig ist.

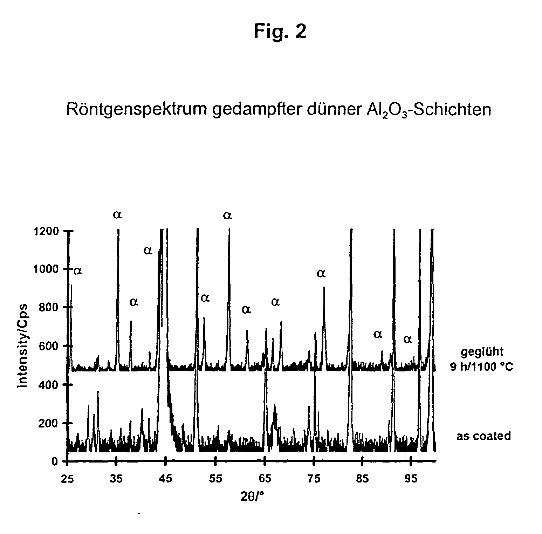

Für dünne gedampfte Aluminiumoxidschichten, abgeschieden bei Substrattemperaturen unterhalb von 900°C, zeigt Fig. 2 die Phasenentwicklung vor und nach dem Glühen bei 1100°C. Die Einstellung der α-Phase infolge der Glühbehandlung wird klar erkennbar.

### Beispiel 2:

### Aluminiumoxidherstellung durch Magnetron-Sputtern und Erzeugung von α-Al₂O₃

Dünne Aluminiumoxidschichten (4-5 µm) wurden durch reaktives Sputtern von einem Al₂O₃-Target erzeugt. Wie das Röntgenbeugungsbild in Fig. 3 verdeutlicht, sind diese Schichten nach der Herstellung röntgen-amorph. Bereits nach einer Glühung 4h/1080°C ist ausschließlich α-Al₂O₃ vorhanden.

### Beispiel 3:

### Komplettes erfindungsgemäß hergestelltes Schichtsystem, Lebensdaueruntersuchung

Auf Stäben einer Superlegierung (IN100) wurden 100-150µm dicke NiCoCrAIY Zwischenschichten mit dem EB-PVD-Verfahren aufgebracht, mittels Kugelstrahlen verdichtet und 4h/1080°C zur Diffusionsanbindung an die Zwischenschicht in einem Vakuumofen (p< 10⁻⁴ mbar) geglüht.

Anschließend wurden 3 Proben mit einer Aluminiumoxidschicht von 6 µm Dicke durch reaktive Al₂O₃-Verdampfung bei 720-800°C Substrattemperatur versehen. Die Proben wurden dann 9h bei 1100°C im Vakuum zur α-Aluminiumoxidbildung und Relaxation geglüht. Anschließend erfolgte die Beschichtung mit einer 270µm dicken kolumnaren YSZ -Wärmedämmschicht durch EB-PVD. Vergleichsproben wurden ohne α-Aluminiumoxidschicht hergestellt.

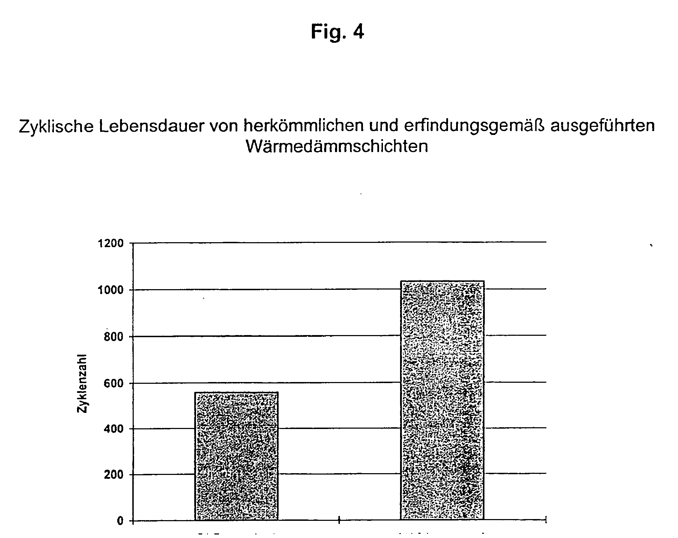

In einem Thermowechselversuch wurde die Lebensdauer bis zum Abplatzen von Wärmedämmschichtbereichen größer als 5mm in einer Dimension ermittelt. Der Zyklus bestand aus 50min Heizphase bis auf 1100°C und 10min Schnellabkühlung mit Preßluft bis nahe Raumtemperatur. Den Vergleich der Lebensdauern zeigt Fig. 4.

Die Lebensdauer des erfindungsgemäß ausgeführten Schichtsystems liegt nahezu doppelt so hoch wie bei herkömmlichen Wärmedämmschichtsystemen.

## Patentansprüche

1. Verfahren zum Beschichten von metallischen Substraten mit einer Metalloxidschicht aus Aluminiumoxid und einer oxidischen Wärmedämmschicht, in dem man
a) das Substrat mit einer 1 bis 10 µm dicken α-Aluminiumoxidschicht durch physikalische Dampfphasen-Abscheidung (PVD) bei einer Temperatur des Substrats im Bereich bis 900 °C mit einer nachgeschalteten Wärmebehandlung des beschichteten Substrats im Temperaturbereich von 900 °C bis 1250 °C im Verlauf von wenigstens 0,5 Stunden und
b) die gemäß a) erhaltene α-Aluminiumoxidschicht in an sich bekannter Weise mit einer Wärmedämmschicht einer Wärmeleitfähigkeit < 3 W/mK und einer Dicke von 10 bis 1000 µmversieht.

2. Verfahren nach Anspruch 1, **dadurch gekennzeichnet, daß** man ein Substrat aus einer Ni- oder Co-Basis-Superlegierung in einkristalliner, polykristalliner oder gerichtet erstarrter Form einsetzt.

3. Verfahren nach Anspruch 1, **dadurch gekennzeichnet, daß** die physikalische Dampfphasen-Abscheidung mittels Magnetron-Sputtern oder Elektronenstrahl-Verdampfung (EB-PVD) von metallischem Aluminium und Reaktion in einer sauerstoffhaltigen Atmosphäre oder von Aluminiumoxid-Targets und/oder - Ingots, ohne zusätzliche Sauerstoffzugabe realisiert wird.

4. Verfahren nach Anspruch 1, **dadurch gekennzeichnet, daß** man die Wärmebehandlung des beschichteten Substrats mit zusätzlicher Sauerstoffzugabe durchführt.

5. Verfahren na**ch** einem der Ansprüche 1 bis 4, **dadurch gekennzeichnet, daß** man bei der Herstellung von magnetron-gesputterten Schichten eine Wärmebehandlung für 4 Stunden bei einer Temperatur von 1080 °C durchführt.

6. Verfahren nach Anspruch 3 oder 4, **dadurch gekennzeichnet, daß** man bei der Herstellung von EB-PVD-Schichten eine Wärmebehandlung im Verlauf von 9 Stunden bei 1100 °C durchführt.

7. Verfahren nach Anspruch 1, **dadurch gekennzeichnet, daß** man eine oder mehrere metallische Zwischenschichten, insbesondere aus der Gruppe der MCrAIYX- oder MAIYX-Schichten,
wobei
M für Ni, Co, Fe oder deren Gemische und
X für gegebenenfalls vorhandene Zusatzelemente, insbesondere Ta, Re, Hf und/oder Si steht oder
eine im wesentlichen aus Aluminium bestehende Diffusionsschicht auf das metallische Substrat in an sich bekannter Weise aufbringt, bevor man die α-Aluminiumoxidschicht herstellt.

8. Verfahren nach Anspruch 1, **dadurch gekennzeichnet, daß** man die Wärmedämmschicht aus ZrO₂-haltigen Keramiken, gegebenenfalls stabilisiert mit Y₂O₃, CeO₂, MgO, Sc₂O₃ oder anderen Seltenerdmetalloxiden, Mullit, Zirkonsilikat, Hafniumoxid oder hochporösem Aluminiumoxid aufbaut.

9. Verfahren nach Anspruch 1, **dadurch gekennzeichnet, daß** man die Wärmedämmschicht mit an sich bekannten Deckschichten gegen Erosion und/oder Korrosion versieht.

10. Bauteile erhältlich nach einem Verfahren gemäß einem der Ansprüche 1 bis 9 umfassend ein metallisches Substrat, eine α-Aluminiumoxidschicht und eine darauf befindliche Wärmedämmschicht.

11. Bauteile nach Anspruch 10 umfassend innengekühlte Turbinenschaufeln oder Brennkammerwände in stationären oder Flugturbinen.

## Claims

1. A process for the coating of metallic substrates with a metal oxide layer of aluminum oxide and an oxidic heat-insulation layer by:
a) coating the substrate with a 1 to 10 µm thick α-alumina layer by physical vapor deposition (PVD) at a temperature of the substrate in the range of up to 900°C with a subsequent heat treatment of the coated substrate in a temperature range of from 900°C to 1250°C in the course of at least 0.5 hour; and
b) providing the α-alumina layer obtained according to a) with a heat-insulation layer having a heat conductivity of < 3 W/mK and a thickness of from 10 to 1000 µm in a per se known manner.

2. The process according to claim 1, **characterized in that** a substrate made of an Ni- or Co-based superalloy is employed in a monocrystalline, polycrystalline or directionally solidified form.

3. The process according to claim 1, **characterized in that** said physical vapor deposition is realized by magnetron sputtering or electron-beam physical vapor deposition (EB-PVD) of metallic aluminum and reaction in an oxygen-containing atmosphere or of alumina targets and/or ingots without additional oxygen supply.

4. The process according to claim 1, **characterized in that** said heat treatment of the coated substrate is performed with additional oxygen supply.

5. The process according to any of claims 1 to 4, **characterized in that** when magnetron-sputtered layers are prepared, a heat treatment is performed at a temperature of 1080°C for 4 hours.

6. The process according to claim 3 or 4, **characterized in that** when EB-PVD layers are prepared, a heat treatment is performed at 1100 °C in the course of 9 hours.

7. The process according to claim 1, **characterized in that** one or more metallic intermediate layers, especially from the group of MCrAIYX or MAIYX layers, wherein M represents Ni, Co, Fe or mixtures thereof and X represents additional elements that may be present, especially Ta, Re, Hf and/or Si, or a diffusion layer essentially consisting of aluminum are applied to the metallic substrate in a per se known manner before said α-alumina layer is prepared.

8. The process according to claim 1, **characterized in that** said heat-insulation layer is built from ZrO₂-containing ceramics, optionally stabilized with Y₂O₃, CeO₂, MgO, Sc₂O₃ or other rare-earth metal oxides, mullite, zirconium silicate, hafnium oxide or highly porous aluminum oxide.

9. The process according to claim 1, **characterized in that** said heat-insulation layer is provided with per se known cover layers against erosion and/or corrosion.

10. Component parts obtainable by a process according to any of claims 1 to 9, comprising a metallic substrate, an α-alumina layer and a heat-insulation layer provided thereon.

11. The component parts according to claim 10, comprising turbine blades or combustion chamber walls with interior cooling in stationary or flight turbines.

## Revendications

1. Procédé pour revêtir des substrats métalliques d'une couche d'oxyde métallique composée d'alumine et d'une couche oxydée de calorifugeage, selon lequel :
a) le substrat reçoit une couche de 1 à 10 microns d'alumine α par dépôt physique en phase vapeur (PVD) à une température du substrat allant jusqu'à 900° C, puis le substrat revêtu est soumis pendant au moins 30 minutes, à un traitement thermique dans la plage de températures allant de 900° à 1250° C
b) la couche d'alumine α déposée selon a) est recouverte d'une manière connue d'une couche de calorifugeage dont la conductibilité thermique est inférieure à 3 W/mK et qui présente une épaisseur de 10 à 1000 microns.

2. Procédé selon la revendication 1, **caractérisé en ce qu'**on utilise un substrat fait d'un superalliage à base de Ni ou de Co, dans une forme monocristalline, polycristalline ou solide orientée.

3. Procédé selon la revendication 1, **caractérisé en ce que** le dépôt physique en phase vapeur est réalisé par pulvérisation au magnetron ou par vaporisation par des faisceaux électroniques (EB-PVD) d'aluminium métallique et réaction dans une atmosphère contenant de l'oxygène, ou de cibles et/ou de lingots d'aluminium, sans addition d'oxygène supplémentaire.

4. Procédé selon la revendication 1, **caractérisé en ce que** le traitement thermique du substrat revêtu s'effectue avec addition d'oxygène supplémentaire.

5. Procédé selon une des revendications 1 à 4, **caractérisé en ce que** la fabrication des couches par pulvérisation au magnetron, comprend un traitement thermique à 1080° C pendant quatre heures.

6. Procédé selon la revendication 3 ou 4, **caractérisé en ce que** la fabrication des couches EB-PVB comprend un traitement thermique à 1100° C pendant neuf heures.

7. Procédé selon la revendication 1, **caractérisé en ce qu'**on dépose sur le substrat métallique de manière connue une ou plusieurs couches métalliques intermédiaires, en particulier du groupe des couches MCrA1YX ou MA1YX dans lesquels M représent Ni, Co, Fe ou leurs mélanges et X des éléments additionnels éventuellement présents, notamment Ta, Re, Hf et/ou Si, ou une couche de diffusion, essentiellement en aluminium, qui est déposée sur le substrat métallique de manière connue en soi, avant de fabriquer la couche d'aluminium.

8. Procédé selon la revendication 1, **caractérisé en ce qu'**on réalise la couche de calorifugeage à partir de céramiques contenant du ZrO₂, éventuellement stabilisées au moyen de Y₂O₃, CeO₂, MgO, SC₂O₃ ou autres oxydes de métaux rares, de mullite, de silicate de zirconium, d'oxyde d'hafnium ou d'alumine hautement poreuse.

9. Procédé selon la revendication 1, **caractérisé en ce qu'**on dote la couche de calorifugeage pour la protéger de l'érosion et/ou de la corrosion, de couches de couvertures connues en elles-mêmes.

10. Composants obtenus par un procédé selon les revendications 1 à 9, qui comprennent un substrat métallique, une couche d'alumine α et sur celle-ci, une couche de calorifugeage.

11. Composants selon la revendication 1, comprenant des ailettes de turbine à refroidissement interne ou des parois de chambres de combustion dans des turbines fixes ou des turbines d'aéronefs.
